Europäisches Patentamt

European Patent Office

Office européen des brevets

(19)

(11) Veröffentlichungsnummer : **0 141 262**
**B1**

(12) **EUROPÄISCHE PATENTSCHRIFT**

(45) Veröffentlichungstag der Patentschrift :
09.09.87

(21) Anmeldenummer : 84111567.8

(22) Anmeldetag : 27.09.84

(51) Int. Cl.⁴ : **H 01 L 23/40**

(54) Einrichtung zum Festhalten eines Kühlkörpers auf der Kühlfläche eines integrierten Bausteins.

(30) Priorität : 29.09.83 DE 3335332

(43) Veröffentlichungstag der Anmeldung :
15.05.85 Patentblatt 85/20

(45) Bekanntmachung des Hinweises auf die Patenterteilung : 09.09.87 Patentblatt 87/37

(84) Benannte Vertragsstaaten :
AT BE CH DE FR GB IT LI NL SE

(56) Entgegenhaltungen :
EP-A- 0 034 282
DE-A- 2 425 723
DE-A- 3 203 609
IBM TECHNICAL DISCLOSURE BULLETIN, Band 23,
Nr. 12, Mai 1981, Seite 5303, New York; USA; F.A.
ALMQUIST et al.: "Spring-clip mounted extruded
aluminum heat sink"

(73) Patentinhaber : **Siemens Aktiengesellschaft Berlin
und München
Wittelsbacherplatz 2
D-8000 München 2 (DE)**

(72) Erfinder : **Hermann, Adam, Dipl.-Ing.
Massmannstrasse 2
D-8000 München 2 (DE)**

EP 0 141 262 B1

**Beschreibung**

Die Erfindung bezieht sich auf eine Einrichtung zum Festhalten eines Kühlkörpers auf der Kühlfläche eines integrierten Bausteins nach dem Oberbegriff des Patentanspruchs 1.

Für die Befestigung von Kühlkörpern auf Einzelhalbleitern wird vielfach die Methode des Festschraubens oder die des Festklemmens durch eine federnde Ausgestaltung des Kühlkörpers praktiziert. Diese Methoden eignen sich aber nicht für die Befestigung von Kühlkörpern auf integrierten Schaltkreisen, insbesonder dann nicht, wenn eine Vielzahl von Anschlüssen an den Seitenflächen des integrierten Bausteins angeordnet sind. eine bekannte Maßnahme sieht deshalb vor, den Kühlkörper unmittelbar auf die Oberseite des integrierten Bausteins zu kleben. Nachteil dieser Methode ist, daß der Kühlkörper nicht ohne Zerstörung vom Baustein gelöst werden kann. Außerdem besteht die Gefahr, daß der frisch angeklebte Kühlkörper bei unmittelbar sich anschließenden Montagearbeiten wegen der noch nicht ausreichend ausgehärteten Kleberschicht rutschen oder sogar herunterfallen kann.

Zur lösbaren Befestigung eines Kühlkörpers auf einem integrierten Baustein ist es bekannt, den Kühlkörper mit Hilfe eines Federbügels von oben her auf den integrierten Baustein zu drücken (Vgl. IBM Technical Disclosure Bulletin, Band 23, Nr. 12, Mai, 1981, Seite 5303). Derartige Federbügel bestehen vielfach aus Federstahlblech und bewirken damit die Gefahr eines Kurzschlusses, weshalb aus Sicherheitsgründen zwischen Federbügel und integriertem Baustein Zwischenlagen aus Isolierstoff erforderlich sind. Dies wiederum hat den Nachteil, daß sich die Montage wegen des erhöhten Material- und Zeitbedarfs entsprechend verteuert. Da die bekannten Federbügel außerdem so gestaltet sind, daß sie den Kühlkörper von oben her auf den integrierten Baustein drücken, wird durch den Federbügel in der Höhe zusätzlicher Raum beansprucht, so daß der Kühlkörper bei einer vorgegebenen Einbauhöhe entsprechend kleiner gemacht werden muß, was zu Lasten der Kühlleistung geht.

Der vorliegenden Erfindung liegt nun die Aufgabe zugrunde, für die sichere Befestigung eines Kühlkörpers auf einem integrierten Bausteine eine möglichst einfache und platzsparende Lösung zu finden.

Die Lösung dieser Aufgabe ergibt sich erfindungsgemäß durch die kennzeichnenden Merkmale des Patentanspruchs 1.

Vorteilhafte Weiterbildungen der Erfindung ergeben sich aus den Unteransprüchen.

Im folgenden wird ein Ausführungsbeispiel der Erfindung anhand der Zeichnung näher erläutert. Dabei zeigen :

Figuren 1, 2 eine erfindungsgemäße Einrichtung zum Befestigen eines Kühlkörpers auf einem integrierten Baustein in montiertem Zustand in Vorder- und Seitenansicht,

Figuren 3, 4 die Einrichtung nach Fig. 1 und 2 in einem ersten und zweiten Montageschritt zur Befestigung des Kühlkörpers am integrierten Baustein,

Figur 5 den zweiten Montageschritt in einer teilweisen Schnittdarstellung der Einrichtung nach Fig. 3 und 4.

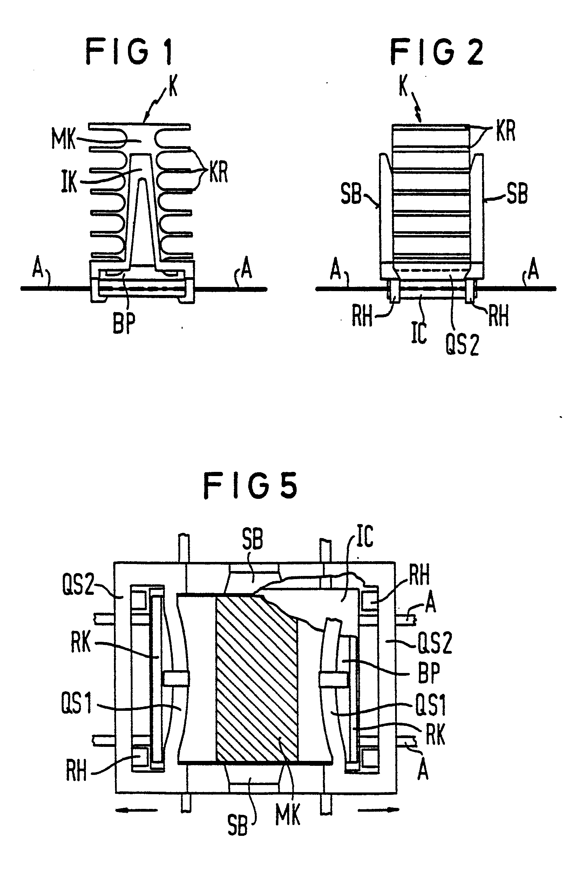

Die Figuren 1 und 2 zeigen in einer Vorder- und Seitenansicht einen Kühlkörper K, der mit seiner Bodenplatte BP auf der Kühlfläche eines integrierten Bausteins IC befestigt ist, dessen Anschlüsse A an den Seitenflächen nach außen geführt sind. Der Kühlkörper K besteht aus der Bodenplatte BP, einem senkrecht auf der Bodenplatte BP stehenden Mittelkern MK und mehreren, auf gegenüberliegenden Seiten des Mittelkerns jeweils übereinander angeordneten Kühlrippen KR. Zur Befestigung des Kühlkörpers K am integrierten Baustein IC dient ein Isolierkörper IK, der aus zwei an den freien Seiten des Kühlkörper-Mittelkerns MK anliegenden Stützbügeln SB besteht, die über erste (in den Figuren 1 und 2 nicht sichtbare) und zweite Querstege QS2 miteinander verbunden sind. An den zweiten Querstegen QS2 sind Rasthaken RH vorgesehen, die die Seitenflächen des integrierten Bausteins IC in den anschlußfreien Bereichen, vorzugsweise in den Eckbereichen klammerartig umgreifen. Zwischen der Bodenplatte BP des Kühlkörpers K und der Deckfläche des integrierten Bausteins IC ist eine dünne Kleberschicht oder eine Wärmeleitpaste vorgesehen bzw. aufgetragen.

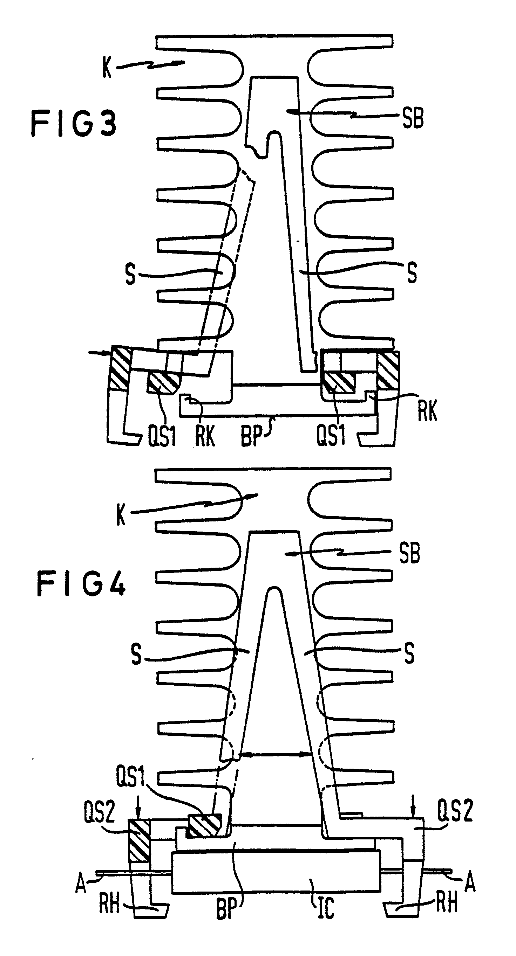

Die Fig. 3 zeigt den ersten Montageschritt zur Befestigung des Isolierkörpers am Kühlkörper. Dabei wird der Isolierkörper mit seinen beiden Stützbügeln SB von unten her über den Kühlkörper K geschoben, wobei die beiden federnden Schenkel S der beiden etwa V-förmig ausgebildeten Stützbügel so weit nach außen gespreizt werden, daß die beiden ersten Querstege QS1 bis in den Raum zwischen Bodenplatte BP und unterster Kühlrippe gelangen und dort durch federndes Zurückklappen der beiden Schenkel hinter einer Rastkante RK einrasten.

Im zweiten Montageschritt, der in Fig. 4 dargestellt ist, wird der Isolierkörper an den außen liegenden zweiten Querstegen QS2 unter Ausnutzung des Federweges der ersten Querstege QS1 weiter nach unten gedrückt. Außerdem werden die beiden Schenkel S der Stützbügel wieder so weit auseinandergespreizt, daß der integrierte Baustein IC von unten eingefügt werden kann. Anschließend federn die Schenkel wieder zurück, wobei der integrierte Baustein IC von den an den zweiten Querstegen QS2 vorgesehenen Rasthaken RH durch zangenartiges Umgreifen an den anschlußfreien Bereichen der Gehäuseseitenflächen erfaßt und gegen die Bodenplatte BP des Kühlkörpers K gedrückt wird (siehe auch Fig. 1). Die Rasthaken RH dienen außerdem als Abstandshalterung gegenüber der den integrierten Baustein tragenden Leiterplatte.

In der Fig. 5 ist der zweite Montageschritt in

einer Draufsicht dargestellt, wobei der Mittelkern MK des Kühlkörpers im Bereich zwischen Bodenplatte BP und der untersten Kühlrippe geschnitten ist. Die Fig. 5 zeigt die beiden Stützbügel SB im gespreizten Zustand, wobei die ersten Querstege QS1 bereits hinter der Rastkante K der Bodenplatte BP eingerastet sind, während die zweiten Querstege QS2 mit den Rasthaken RH außen am Gehäuse des integrierten Bausteins IC vorbei nach unten gedrückt werden, damit die seitlich von den Anschlußdrähten A des integrierten Bausteins IC angeordneten Rasthaken RH beim anschließenden Zurückfedern der Stützbügelschenkel unterhalb des Gehäuses einrasten können. Die Anordnung der Rasthaken RH ist im übrigen so gewählt, daß der Isolierkörper auch in einer handelsüblichen Meß- und Transporthalterung zusammen mit dem Kühlkörper auf dem integrierten Baustein montiert werden kann, wobei die Rasthaken in dafür vorgesehene Aussparungen in der Meß- und Transporthalterung eintauchen.

**Patentansprüche**

1. Einrichtung zum Festhalten eines aus einer Bodenplatte und mehreren auf zwei gegenüberliegenden Seiten eines senkrecht auf der Bodenplatte stehenden Mittelkerns jeweils übereinander angeordneten Kühlrippen bestehenden Kühlkörpers auf der Kühlfläche eines integrierten Bausteins, dessen Anschlüsse an den Seiten herausgeführt sind, gekennzeichnet durch einen Isolierkörper (IK) der zwei, jeweils an den freien Seiten des Kühlkörper-Mittelkerns (MK) anliegende Stützbügel (SB) mit jeweils zwei federnd nach außen spreizbaren Schenkeln (S) aufweist, deren freie Enden mit den jeweils gegenüberliegenden freien Enden des jeweils anderen Stützbügels sowohl über je einen ersten, ander Oberseite der Bodenplatte (BP) des Kühlkörpers (K) sich federnd abstützenden Quersteg (QS1) als auch über je einen zweiten Quersteg (QS2), der mit Rastelementen (RH) zum Festklemmen am integrierten Baustein (IC) versehen ist, miteinander verbunden sind.

2. Einrichtung nach Anspruch 1, dadurch gekennzeichnet, daß die beiden Schenkel (S) des Stützbügels (SB) in etwa V-förmig angeordnet sind.

3. Einrichtung nach Anspruch 2, dadurch gekennzeichnet, daß der Mittelkern (MK) des Kühlkörpers (K) konusförmig ausgebildet ist, derart, daß die Konusflächen weitgehend parallel zu den jeweils zugehörigen Schenkeln des V-förmigen Stützbügels verlaufen.

4. Einrichtung nach einem der vorhergehenden Ansprüche, dadurch gekennzeichnet, daß die freien Enden der Stützbügel-Schenkel (S) parallel zur Bodenplatte (BP) des Kühlkörpers (K) verlaufend nach außen gerichtet sind.

5. Einrichtung nach einem der vorhergehenden Ansprüche, dadurch gekennzeichnet, daß an den Außenkanten der Bodenplatte (BP) eine Rastkante (RK) für den sich an der Oberfläche der Bodenplatte abstützenden ersten Quersteg (QS1) vorgesehen ist.

6. Einrichtung nach einem der vorhergehenden Ansprüche, dadurch gekennzeichnet, daß der erste Quersteg (QS1) in seinem Auflagebereich auf der Bodenplatte (BP) einen sich gegen die Rastkante (RK) abstützenden Anschlag aufweist.

7. Einrichtung nach einem der vorhergehenden Ansprüche, dadurch gekennzeichnet, daß die an den zweiten Querstegen (QS2) vorgesehenen Rastelemente als die Seitenflächen des integrierten Bauseins umgreifende Rasthaken (RH) ausgebildet sind.

8. Einrichtung nach einem der vorhergehenden Ansprüche, dadurch gekennzeichnet, daß zwischen der Deckfläche des integrierten Bausteins (IC) und der Bodenplatte (BP) des Kühlkörpers (K) eine Kleberschicht vorgesehen ist.

9. Einrichtung nach einem der Ansprüche 1 bis 7, dadurch gekennzeichnet, daß zwischen der Deckfläche des integrierten Bausteins (IC) und der Bodenplatte (BP) des Kühlkörpers (K) eine dünne Schicht aus wärmeleitfähigem Material vorgesehen ist.

**Claims**

1. A device for fixing a cooling member, composed of a base plate and of a plurality of cooling ribs which are in each case arranged above one another on two opposite sides of a central core standing at right angles to the base plate, to the cooling face of an integrated module whose terminals lead outwards at its sides, characterised by an insulating member (IK) which is provided with two supporting yokes (SB) which each abut against the free sides of the cooling member central core (MK) and each of which has two resilient flanks (S) which can be spread apart and the free ends of which are connected to the opposite free ends of the respective other supporting yoke both via a first cross-member (QS1) which rests resiliently against the top of the base plate (BP) of the cooling member (K), and via a second cross-member (QS2) which is provided with locking elements (RH) which are to be clamped to the integrated module (IC).

2. A device as claimed in Claim 1, characterised in that the two flanks (S) of the supporting yoke (SB) are arranged approximately in a V-formation.

3. A device as claimed in Claim 2, characterised in that the central core (MK) of the cooling member (K) is of conical formation, in such manner that the conical faces extend substantially in parallel to the associated flanks of the V-shaped supporting yoke.

4. A device as claimed in one of the preceding Claims, characterised in that the free ends of the supporting yoke flanks (S) are directed outwards, extending in parallel to the base plate (BP) of the cooling member (K).

5. A device as claimed in one of the preceding Claims, characterised in that the outer edges of the base plate (BP) are provided with a locking edge (RK) for the first cross-member (QS1) which rests against the upper surface of the base plate.

6. A device as claimed in one of the preceding Claims, characterised in that in the zone in which it is supported on the base plate (BP) the first cross-member (QS1) has a stop means which rests against the locking edge (RK).

7. A device as claimed in one of the preceding Claims, characterised in that the locking elements with which the second cross-members (QS2) are provided consist of locking hooks (RH) which engage round the lateral surfaces of the integrated module.

8. A device as claimed in one of the preceding Claims, characterised in that a layer of adhesive is provided between the top surface of the integrated module (IC) and the base plate (BP) of the cooling member (K).

9. A device as claimed in one of Claims 1 to 7, characterised in that a thin layer of heat-conducting material is provided between the top surface of the integrated module (IC) and the base plate (BP) of the cooling member (K).

**Revendications**

1. Dispositif pour fixer un dissipateur de chaleur, constitué par une plaque de base et plusieurs nervures de refroidissement disposées en étant respectivement superposées, sur deux côtés opposés d'un noyau central monté sur la plaque de base, sur la surface de refroidissement d'un module intégré, dont les bornes ressortent sur les côtés, caractérisé par un corps isolant (IK) qui comporte deux étriers de support (SB) s'appliquant respectivement contre les côtés libres du noyau central (MK) du dissipateur de chaleur et comportant chacun deux branches (S) pouvant être écartées élastiquement vers l'extérieur, les extrémités libres des branches de cet étrier de support ainsi que les extrémités libres respectivement opposées de l'autre étrier de support respectif étant reliées entre elles aussi bien par l'intermédiaire de premières barrettes transversales respectives (QS1) prenant appui élastiquement contre la face supérieure de la plaque de base (BP) du dissipateur de chaleur (K), que par l'intermédiaire de secondes barrettes transversales respectives (QS2), qui sont munies d'organes d'encliquetage (RH) servant à réaliser la fixation par blocage sur le module intégré (IC).

2. Dispositif suivant la revendication 1, caractérisé par le fait que les deux branches (S) de l'étrier de support (SB) sont disposées approximativement avec la forme d'un V.

3. Dispositif suivant la revendication 2, caractérisé par le fait que le noyau central (MK) du dissipateur de chaleur (K) est réalisé avec une forme conique de telle sorte que les surfaces coniques sont dans une large mesure parallèles aux branches respectives associées de l'étrier de soutien en forme de V.

4. Dispositif suivant l'une des revendications précédentes, caractérisé par le fait que les extrémités libres des branches (S) des étriers de support sont dirigées vers l'extérieur en s'étendant parallèlement à la plaque de base (BP) du dissipateur de chaleur (K).

5. Dispositif suivant l'une des revendications précédentes, caractérisé par le fait qu'il est prévu, sur les bords extérieurs de la plaque de base (BP), un bord d'encliquetage (RK) pour la première barrette transversale (QS1) qui prend appui sur la surface de la plaque de base.

6. Dispositif suivant l'une des revendications précédentes, caractérisé par le fait que la première barrette transversale (QS1) comporte, dans sa zone d'appui sur la plaque de base (BP), une butée prenant appui contre le bord d'encliquetage (RK).

7. Dispositif suivant l'une des revendications précédentes, caractérisé par le fait que les organes d'encliquetage prévus sur les secondes barrettes transversales (QS2) sont réalisées sous la forme de crochets d'encliquetage (RH) enserrant les surfaces latérales du module intégré.

8. Dispositif suivant l'une des revendications précédentes, caractérisé par le fait qu'une couche de colle est prévue entre la surface supérieure du module intégré (IC) et la plaque de base (BP) du dissipateur de chaleur (K).

9. Dispositif suivant l'une des revendications 1 à 7, caractérisé par le fait qu'il est prévu une mince couche d'un matériau thermoconducteur entre la surface supérieure du module intégré (IC) et la plaque de base (BP) du dissipateur de chaleur (K).

# FIG 1

# FIG 2

# FIG 5

FIG3

FIG4